# DEMANDE DE BREVET EUROPEEN

(11) **EP 2 200 181 A1**
(43) Date de publication de la demande: **23.06.2010**
(21) Numéro de dépôt: 09009119.0
(22) Date de dépôt: 13.07.2009
(51) Int. Cl.: H03K 17/687, H01R 33/76

(54) **Commande anti-charbonnage par interruption en tension pour aéronef.**

(30) Priorité: 16.12.2008 FR 0807067
(71) Demandeur: EUROCOPTER, 13725 Marignane Cédex (FR)
(72) Inventeur: Certain, Bernard, 13090 Aix en Provence (FR)
(74) Mandataire: GPI & Associés

(57) **Abrégé**

L'invention concerne un aéronef (1) avec une commande sensible au charbonnage. Cette commande comporte un circuit (13) de puissance, une touche (24) de manoeuvre manuelle et un tronçon (27) de liaison à intensité faible.

Une grille (33) d'un agencement (20) de coupure sous forme de transistor à effet de champ à grille métal-oxyde ou MOSFET est reliée audit tronçon (27) de liaison, et des porte et drain de cet agencement (20) sont montés en série entre des jonctions (19, 22) d'entrée et de sortie du circuit (13) sous tension nominale.

## Description

La présente invention se rapporte au domaine technique général des commandes électriques à actionnement manuel pour aéronefs.

Plus particulièrement, l'invention cherche à sécuriser certaines commandes manuelles d'interruption électrique.

En effet, un dysfonctionnement particulier d'une telle commande s'est avéré être la cause d'un certain nombre d'incidents ou accidents aériens.

Ces défaillances d'interruption électrique apparaissent suite à une altération ou à une destruction due à la formation répétée d'arcs électriques entre les contacts de certaines commandes.

La conséquence de ces arcs est, à plus ou moins brève échéance d'altérer, de changer ou d'inverser la logique de commande.

Cette altération ou destruction des contacts est appelée « charbonnage », dans le langage aéronautique courant.

De telles commandes sensibles au charbonnage sont remarquables par au moins le premier des trois aspects suivants.

En premier lieu, les commandes auxquelles l'invention est destinée agissent de manière à fermer ou ouvrir des tronçons de circuits électriques dédiés à une électronique qualifiée de puissance.

Il s'agit d'une électronique où circule un courant d'intensité élevée en comparaison avec des courants ne visant qu'à porter une information, typiquement pour un traitement logique.

Par exemple, l'électronique de puissance à laquelle l'invention s'applique est alimentée par un courant sous une tension nominale de 28,5 Volts (V), ce courant servant à l'alimentation électrique générale de l'aéronef.

En second lieu, la disposition de ces commandes ainsi que leur ergonomie sont étudiées pour permettre leur manipulation aisée et rapide, par exemple par prise en main. C'est pour cette raison que ces commandes manuelles sont appelées parfois « à portée de main ».

Par exemple, il s'agit de commandes agencées dans un poste de pilotage, sur un manche de commande de vol d'hélicoptère e.g. son manche de contrôle du pas cyclique de son rotor principal encore appelé voilure tournante.

Certains interrupteurs installés sur la planche de bord, sont également inclus aux commandes concernées par l'invention, ceux-ci étant manipulés particulièrement souvent.

Notons que certaines commandes à distance pour aéronefs radioguidés, par exemple des drones ou des planeurs télécommandés, sont également sensibles au charbonnage. De fait, de telles commandes sont concernées par l'invention, même si l'opérateur de contrôle intervient à distance sur celles-ci via un ensemble de commande situé hors de l'aéronef.

En troisième lieu, ces commandes sont souvent actionnées en cas d'urgence et / ou agissent sur des fonctions vitales de l'aéronef. De fait, leur charbonnage est totalement inacceptable.

Par exemple, de telles commandes vitales actionnent un siège éjectable dans un avion moderne, l'autodestruction d'un drone en cas de perdition, ou encore provoquent la mise en marche ou l'arrêt d'urgence d'un réseau d'alimentation hydraulique au sein d'un hélicoptère qui agit notamment sur son rotor principal ou son rotor arrière.

Par souci de clarté, les technologies existantes ainsi que les problèmes techniques qu'elles rencontrent sont d'abord exposés de manière générale.

Ce n'est qu'ensuite que sont regroupées les citations de divers documents antérieurs se rapportant à ces technologies.

Pour illustrer ces problèmes, reprenons les exemples déjà mentionnés.

Suite à un charbonnage des contacts d'une commande sensible, le lancement du siège éjectable hors de l'avion concerné est inhibé. L'autodestruction du drone en perdition n'intervient pas. Il s'avère impossible de mettre en arrêt d'urgence le réseau d'alimentation hydraulique d'un hélicoptère, ce qui peut provoquer des efforts importants aux commandes cycliques et engendrer un posé en catastrophe, voire pire.

A l'heure actuelle, l'approche usuelle pour tenter de pallier ces problèmes, serait le changement systématique, régulier et à l'identique des commandes à risque de charbonnage. Ceci est fastidieux et coûteux, voire impossible sur certains terrains d'opération.

Une alternative d'un point de vue purement théorique, serait l'adjonction de diodes et de relais en parallèle du circuit électrique de commande. Ceci pourrait être vu comme un palliatif au risque de charbonnage de tels interrupteurs.

Toutefois, il est actuellement inacceptable, voire impossible en pratique, de vérifier régulièrement (par exemple toutes les 500 heures de vol) tous les composants ainsi adjoints.

Il existe également un risque de panne dormante dans le cas de commande dédoublée, c'est-à-dire redondante.

De plus, de telles adjonctions pourraient entraîner un alourdissement des appareils, alors même que ces derniers font l'objet depuis toujours à de véritables « campagnes de réduction de masse».

En outre, il parait ici préférable d'éviter le recours à des composants non « statiques » ou à fort dégagement thermique, comme par exemple les relais.

En bref, l'invention répond donc des problèmes auxquels à ce jour, aucune solution pratique n'a été apportée. Ainsi, elle vise à améliorer la sécurité des aéronefs, en rendant fiables des commandes d'interruption soumises au risque de charbonnage.

Dans la pratique, il n'est cependant pas évident de fiabiliser des commandes d'aéronef, sensibles au charbonnage, contre ce type de risque.

L'enjeu est d'autant plus considérable que les aéronefs concernés sont non seulement les nouveaux appareils en cours de conception ou de fabrication, mais également ceux qui volent déjà actuellement.

Ceci pose un problème incident, car l'invention doit permettre pour des appareils opérationnels à ce jour, une modification aisée, rapide et économique du matériel risquant le charbonnage, par une commande sécurisée conforme à l'invention.

Notamment, ceci implique de limiter au minimum les modifications matérielles apportées aux câblages électriques concernés, voire de totalement éviter ces modifications, si ce n'est par remplacement d'un seul et unique dispositif. On parle à ce sujet d'interchangeabilité.

En effet, il n'est pas envisageable ici de revoir en entier un circuit électrique de commande, ne serait-ce que pour des raisons de coût, de temps, et liées aux besoins de reprendre à la base toute l'homologation dudit circuit.

A moindre échelle, l'échange sur les appareils existants d'une commande risquant de subir un charbonnage, par un dispositif interrupteur sécurisé, autant que les remplacements de maintenance préventive, doivent être rapides, économiques et aisés, notamment sans démontage conséquent au sein de l'aéronef.

En outre, les aéronefs sont parfois exposés à des conditions d'utilisation ou des environnements soumis à des nuisances, contre lesquelles les commandes -notamment vitales- doivent être protégées, afin de garantir un bon fonctionnement de l'appareil, même face à de telles conditions.

Il est en effet courant que la mission d'un aéronef l'expose à des températures extrêmement chaudes ou froides, des tempêtes magnétiques, voire à une pollution nucléaire.

Enfin, l'une des particularités des commandes « à portée de main » est que ces commandes ne doivent en aucun cas faire subir à leur utilisateur des sensations désagréables d'échauffement à leur contact, à fortiori des brûlures.

Or, on a constaté que les commandes à interrupteurs agissant directement sur la tension de puissance, provoquaient parfois un échauffement désagréable de leur entourage, par exemple d'une poignée ou d'une manette de commande.

De plus, un pareil échauffement favorise l'apparition d'arcs de charbonnage.

Ces problèmes parfois antinomiques ayant été exposés, citons maintenant divers documents à considérer en regard de l'invention.

Notons qu'à ce jour, ni la littérature ni la pratique ne semblent avoir proposé de solution à ces problèmes, telle que celle de l'invention.

Le document FR 2 072 870 décrit un circuit de commutation momentanée par des interrupteurs commandés manuellement, et utilisant plusieurs transistors à effets de champ de type métal-oxyde-silicium. Ce circuit vise à éviter les effets perturbateurs des rebonds de contacts et le bruit de la ligne de transmission.

Ce circuit est réalisé sur un substrat semi-conducteur unique, et le prix de ces circuits supplémentaires est compensé par les économies de poids réalisées. Les transistors sont de type MOS à canal P enrichi, pour qu'un potentiel négatif -à décroissance lente-indique un niveau logique « 1 ». Les transistors étant en série, ceci n'a aucun effet sur le reste du circuit.

Le document FR 2 231 090 décrit un circuit éliminateur de vibrations de contact, à faible consommation de puissance, pour un commutateur mécanique ayant tendance à vibrer et donc à générer une série d'impulsions plutôt qu'une impulsion unique.

Ce circuit alimenté par une batterie à très basse tension de traitement logique, est destiné à une montre électronique et comporte une pluralité de transistors à effet de champ métal-oxyde-semi-conducteurs réalisés sur un substrat unique. Ces transistors sont à couplage croisé.

Le document FR 2 907 981 décrit un système de stockage d'énergie électrique à charge maitrisée, par exemple pour assurer la continuité de l'alimentation durant le démarrage d'un avion, alors que les réacteurs ne sont pas actifs.

Un convertisseur est proposé à cette fin, qui comporte une diode à roue libre. Il comporte aussi un interrupteur automatique (c'est-à-dire non manuel). Par exemple, l'interrupteur automatique est de type MOSFET et est disposé sur une ligne dérivée entre une inductance de stockage et la diode. Une résistance de mesure est disposée sur la ligne dérivée.

Le document US 1 900 018 décrit de manière théorique un contrôle automatique de courant électrique à transistor à effet de champ et à grille métal-oxyde, comportant trois bornes qui forment un drain, une source et ladite grille.

Ce document de 1933 est l'oeuvre de l'inventeur de ce type de transistors, qui ne feront leur apparition sous forme de circuits intégrés que trente ans plus tard.

Les avantages de ce contrôle sont l'absence d'échauffement en comparaison avec un filament, et le faible Voltage nécessaire à son fonctionnement. Les applications évoquées sont un amplificateur et un détecteur.

Le document US 5 982 156 décrit un convertisseur automatique à rétrocontrôle, pour bus d'alimentation électrique d'un avion. Un arrangement en boucle ouverte suit un algorithme de régulation de sortie, et est connecté à un circuit intégré comportant un ou plusieurs transistors de commutation, par exemple sous formes de MOSFET de puissance.

Le document WO 2007 015 485 décrit des moyens de contrôle automatique d'une valve de contrôle solénoïde, en fonction de fréquences obtenues pour différents Voltages.

Quant à la présente invention, elle vise à proposer une commande d'interruption électrique à actionnement manuel c'est-à-dire non automatique, pour un circuit électronique de puissance dans un aéronef quelconque, et qui soit :
- sécurisée et fiable, c'est-à-dire sans risque de charbonnage;
- apte à être facilement agencée « à portée de main » et / ou à agir sur une fonction vitale de l'aéronef ;
- interchangeable (d'installation rapide et aisée, en remplacement ou en premier montage) ;
- compatible avec le cahier des charges rigoureux de l'aéronautique (compacte, légère, résistante aux perturbations électromagnétiques, etc.) ; et
- de fonctionnement « statique », c'est-à-dire « en tension » sans basculement mécanique de la ligne de puissance, et présentant autant que faire se peut une bonne résistance aux nuisances.

A cet effet, divers modes de réalisation soit de dispositif, soit de système de commande, ainsi que d'aéronef selon l'invention, sont définis notamment par les caractéristiques suivantes.

Un objet de l'invention est un dispositif de commande électrique, manuelle et sensible au charbonnage pour un aéronef. Ce dispositif assure le passage ou la coupure d'un courant nominal de puissance au sein d'un circuit de puissance avec un tronçon de phase reliant le dispositif à une phase, un tronçon de masse reliant le dispositif à une masse et une touche de manoeuvre manuelle coopérant avec un agencement de coupure dudit courant nominal.

Selon une caractéristique de l'invention, ce dispositif de commande comporte en outre, un tronçon de dérivation avec une section résistante de liaison, en entrée de laquelle est raccordé un organe interrupteur qui est fonctionnellement relié à ladite touche manuelle.

En sortie de la section résistante est raccordée une grille d'un agencement ou composant de coupure à transistor à effet de champ à grille métal-oxyde de type MOSFET.

Cet agencement de coupure comporte une porte et un drain montés en série entre les tronçons de phase et de masse du circuit sous tension nominale.

Dans une réalisation, le dispositif de commande est surabondant au sens où l'agencement de coupure autorise des coefficients S_{V} et S_{A} au moins compris entre 1,5 et 3 de sorte que :
- Tension nominale du dispositif de commande x S_{V} ≤ Tension de spécification de l'agencement de coupure ;
   et / ou
- Intensité nominale du dispositif de commande x S_{A} ≤ Intensité de spécification de l'agencement de coupure

Dans un exemple de réalisation, la tension de spécification de l'agencement de coupure surabondant est de l'ordre de 35 à 65 Volts et l'intensité de spécification de cet de agencement de coupure est de l'ordre de 20 à 80 Ampères, alors que les valeurs correspondantes observées au sein du circuit de puissance sont respectivement de l'ordre de 28,5 Volts et 3 à 10 Ampères.

Selon un mode de réalisation, le dispositif comporte un transistor unique à effet de champ à grille métal-oxyde, ce transistor faisant partie intégrante de l'agencement de coupure.

Selon un autre mode de réalisation, ledit agencement de coupure à transistor à effet de champ à grille métal-oxyde fait partie d'un composant intégré, par exemple sous forme de boîtier unitaire.

Selon encore une autre réalisation, ledit agencement de coupure à transistor à effet de champ à grille métal-oxyde fait partie d'un composant intégré avec un composant résistant et / ou une diode de roue libre, par exemple cette diode est de type Zenner et / ou l'impédance de dudit composant résistant est inférieure ou égale à 10.000 ou 20.000 Ohms.

Un autre objet de l'invention vise un système de commande, qui comporte au moins un dispositif tel qu'exposé plus haut.

Au sein de ce dispositif de commande qui est intégré, sont formés en parallèle la section de liaison à faible intensité ainsi que la section en série avec l'agencement de coupure du nominal.

Dans ce système, ledit dispositif comporte un boîtier intégré, avec à une interface externe, des plots de connexion à des points de jonction du circuit de puissance, des point de jonction au tronçon dérivé, et des guides d'insertion tels que des glissières, qui permettent une insertion par coulissement rectiligne dudit dispositif de commande dans un logement sensiblement complémentaire du système formant alors réceptacle.

Une réalisation de ce système comporte une pluralité de dispositifs de commande.

Encore un autre objet de l'invention vise un aéronef.

Selon des réalisations, destinées à un aéronef à voilure tournante, un tel système de commande est au moins en partie intégré à au moins :
- une commande de vol, telle que le manche de pas cyclique ou le levier de pas collectif d'un hélicoptère ; et / ou
- une planche de bord ; et / ou
- un pupitre de contrôle.

Dans une réalisation, destinée à un aéronef radio guidé, au moins une partie du système de commande est embarquée dans l'aéronef, tandis qu'au moins la touche de manoeuvre est intégrée à un ensemble hors bord c'est-à-dire non-embarqué, par exemple destiné à être porté par un opérateur au sol et relié à l'aéronef par une liaison sans fil, de type radiofréquence par exemple.

L'invention est maintenant décrite en référence à des exemples de réalisation, donnés à titre non limitatif et illustrés par les dessins annexés, dans lesquels :
- la figure 1 est une vue schématique en perspective d'élévation longitudinale, qui illustre une réalisation d'aéronef équipé et apte à mettre en oeuvre la commande sécurisée conforme à l'invention ;
- la figure 2 est une vue partielle schématique en perspective d'élévation longitudinale, d'un détail en écorché d'une réalisation de poste de pilotage d'aéronef équipé et apte à mettre en oeuvre la commande sécurisée conforme à l'invention ;
- la figure 3 est une vue partielle schématique en perspective d'élévation longitudinale, qui illustre une réalisation de manche collectif d'hélicoptère à poignée tournante, équipé et apte à mettre en oeuvre la commande sécurisée de coupure d'urgence du circuit hydraulique de l'appareil, conformément à l'invention ;
- la figure 4 est un schéma qui illustre partiellement un circuit de commande, avec des dispositifs et systèmes conformes à l'invention ; et
- la figure 5 est une vue partielle schématique qui illustre une réalisation de dispositif de commande d'interruption sécurisée conforme à l'invention, ici avec un composant MOFSET de type P, dont le mode d'opération est dit à inversion.

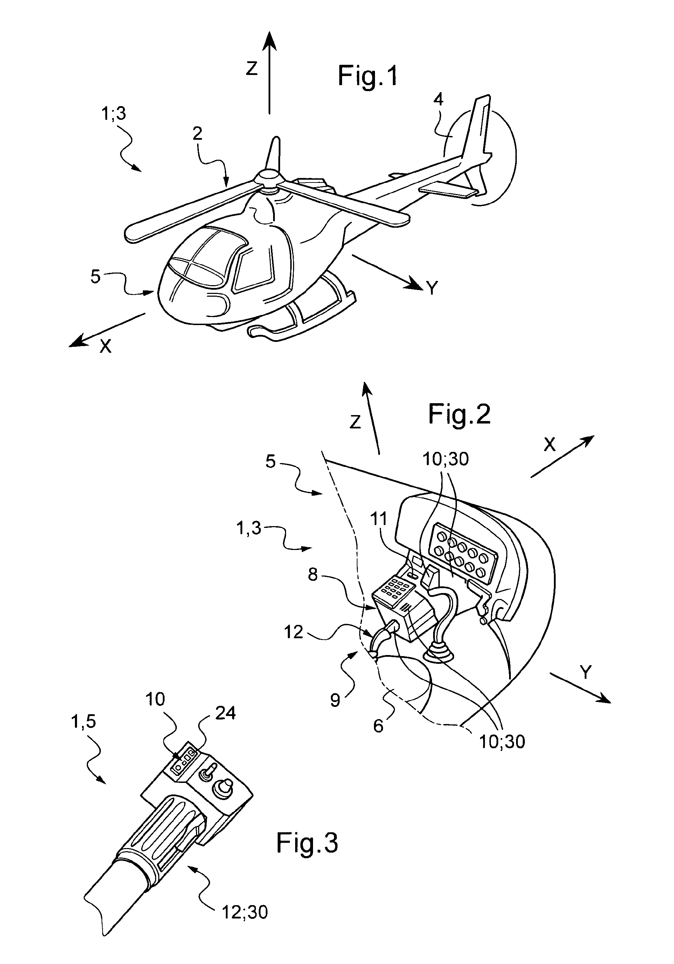

Dans l'ensemble des figures 1 à 5, les éléments similaires sont désignés par les mêmes numéros de référence.

Ainsi, la référence numérique 1 désigne de façon générale un aéronef.

Sur les figures 1 et 2 sont représentées trois directions X, Y et Z orthogonales les unes aux autres, qui forment un repère orthogonal X, Y, Z.

Une direction X dite longitudinale, correspond aux longueurs ou dimensions principales des structures décrites. Une autre direction Y dite transversale, correspond aux trajectoires ou coordonnées latérales des structures décrites. Une troisième direction Z est dite d'élévation et correspond aux dimensions en hauteur et altitude des structures décrites.

Les directions X et Y définissent conjointement un plan X, Y dit principal de l'aéronef 1 évoqué.

Sur la figure 1, l'exemple d'aéronef 1 est un hélicoptère 3 conforme à l'invention, avec un rotor 2 unique de propulsion et de sustentation, ainsi qu'un rotor 4 anti-couple.

Mais on l'a vu, l'invention ne se limite nullement aux aéronefs à voilure tournante, et peut utilement être appliquée à de nombreux aéronefs tels que des avions, des dirigeables, des planeurs ou des drones, etc.

Notons que pour les aéronefs 1 pilotés à distance tels que les planeurs ou drones, un avantage supplémentaire de l'invention est de rendre les commandes embarquées encore plus silencieuses, ce qui est particulièrement utile dans le cas d'une mission d'observation furtive ou d'espionnage.

En effet, les arcs de commandes sont accompagnés d'un bruit qui nuit à la discrétion sonore de tels aéronefs.

Afin de piloter un aéronef 1 quelconque, un poste de contrôle est nécessaire, comme illustré en 5 sur les figures 1 et 2.

Sur les figures 1 à 3, ce poste 5 est dans la cabine de l'hélicoptère 3. Mais dans des réalisations de l'invention pour aéronef 1 radioguidé ou téléguidé, l'interface homme-machine correspondant fonctionnellement à ce poste 5, est un simple ensemble externe à l'aéronef 1, non embarqué ou hors bord.

Dans un cas comme dans l'autre, un opérateur humain (non représenté) peut agir sur des touches manuelles de manoeuvre de diverses commandes, par exemple pour ajuster le pas des pales du rotor 2, dans le cas de l'hélicoptère 3.

Pour illustrer une application de l'invention avec l'hélicoptère 3, une telle commande permet in fine d'agir par exemple sur le pas cyclique ou le pas collectif des pales du rotor 2.

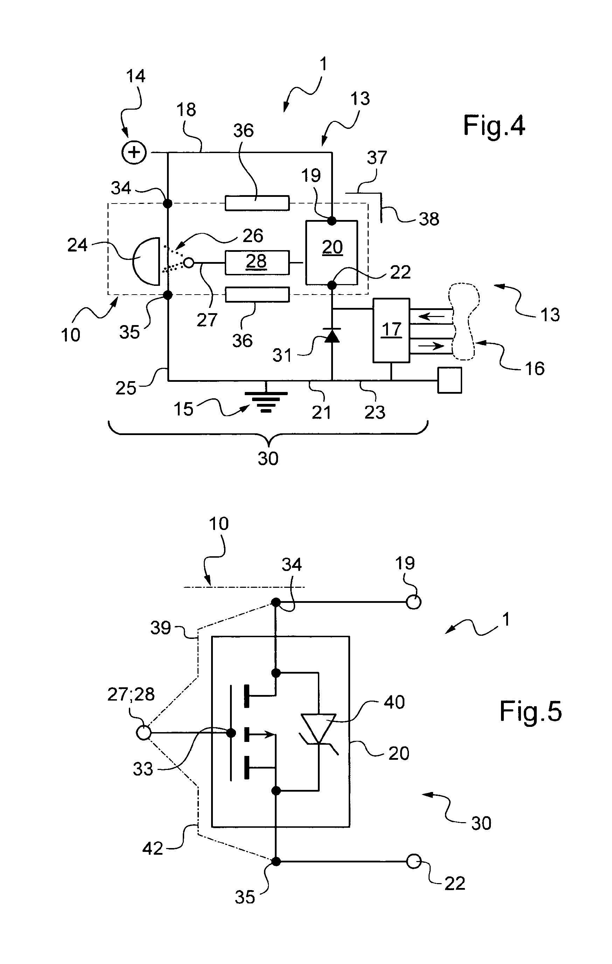

Etant actionnées par un opérateur humain, on parle de commandes manuelles. Mais on verra ultérieurement qu'en réponse à ces instructions humaines, c'est d'abord un circuit de puissance électrique qui réagit et qui à son tour pilote dans l'exemple de la figure 4, un réseau hydraulique, lequel intervient finalement sur le pas desdites pales.

Ces commandes manuelles sont de type électrique, mais sont à distinguer des contrôleurs automatiques, dont l'origine des instructions ne provient que de signaux logiques sans nécessiter d'action humaine pour les initier, comme dans l'exemple d'un calculateur de bord.

Une autre différence par rapport aux contrôleurs automatiques, est que les commandes manuelles agissent directement sur un circuit électrique de puissance, par exemple sous une tension nominale de 28,5 Volts comme dans le cas de l'aéronef 1.

Quant aux contrôleurs automatiques, ils sont simplement intégrés à des circuits logiques où les variations d'instructions, le plus souvent binaires, interviennent dans une gamme particulièrement faible de tension, en comparaison avec celle des circuits de puissance.

La figure 2 montre plus en détails, un exemple de poste 5 de contrôle, embarqué à bord de la cabine de l'hélicoptère 3.

Dans le cas d'un aéronef 1 radio commandé, les commandes manuelles sont en partie déportées hors bord, du moins en ce qui concerne les touches manuelles de manoeuvre ou « joysticks ». Ces touches sont sur un ensemble non embarqué usuellement porté par l'opérateur à distance de cet appareil. Des composants de contrôle du circuit électrique de puissance sont quant à eux embarqués dans cet appareil radio commandé.

Sur la figure 2, le poste 5 comporte de manière classique en face longitudinalement (suivant X) d'un siège 6 d'assise du pilote, une planche de bord 7, un pupitre 8 de commandes dites systèmes (latéralement vers l'avant de ce siège 6), et un bloc manettes 9 (agencé quant à lui transversalement audit siège 6, suivant Y).

Au sein du poste 5, sont agencées diverses commandes manuelles, dont la disposition ainsi que l'ergonomie -en particulier celles de leurs touches manuelles de manoeuvre respectives- sont étudiées pour permettre leur manipulation aisée et rapide.

On a vu plus haut que de telles commandes manuelles, sont appelées ici « à portée de main ».

Sur les figures 2 et 3, cette fonctionnalité se matérialise essentiellement sous la forme d'un dispositif 10 de commande, lui-même intégré à un circuit 13 de puissance de l'aéronef 1, et à un système 30 de commande agencé dans le poste 5.

Un tel système 30 comporte typiquement un ou plusieurs dispositifs 10 de commande qui sont distincts, et par exemple plusieurs commandes de vol, telles que celles qui sont intégrées à un manche de pas cyclique 11 ou à un levier de pas collectif 12 de l'hélicoptère 3.

Notons que dans les systèmes 30 de commande à distance pour aéronef 1 radiocommandé, au moins une partie, dont au moins une touche de manoeuvre manuelle du système 30, est disposée à portée de main de l'opérateur humain, mais hors de l'appareil. Par exemple, un tel système 30 présente une ou plusieurs touches manuelles sur un ensemble portable d'émission-réception sans fil, et une ou plusieurs commandes d'interruption électrique qui sont quant à elles embarquées.

Une partie du système 30 n'est donc pas embarquée dans l'aéronef 1, mais déportée au sol sur un ensemble d'émission-réception sans fil. Néanmoins, une partie de ce système 30 de commande est embarquée au sein de l'aéronef 1, notamment celles qui font partie du circuit 13.

En se reportant maintenant à la figure 4, on voit en partie ledit circuit électrique 13 de l'aéronef 1 selon l'invention.

Dans sa finalité, ce circuit 13 est un circuit de puissance, où circule un courant électrique continu sous une tension nominale de 28,5 Volts, entre une phase positive 14 et une masse 15.

Bien que cela ne soit pas illustré, dans le cas de l'hélicoptère 3, ce circuit 13 est alimenté par une batterie possédant au moins une pluralité d'accumulateurs cadmium-Nickel, avec une capacité nominale de l'ordre de 16 Ampère-heure pour une puissance instantanée de l'ordre de 10,7 kilo Watts, et par une génératrice assurant la délivrance d'un courant continu sous tension stabilisée à sensiblement 28,5 Volts. Ces alimentations, dont le fonctionnement peut être complémentaire, sont symboliquement représentées sous la même référence 14 (phase positive du circuit 13).

Ce circuit 13 sert entre autres à contrôler un réseau hydraulique schématiquement représenté en 16 sur la figure 4, à bord de l'aéronef 1, ce réseau 16 étant lui-même apte à agir sur le pas des pales du rotor 2 et ainsi sur le vol de cet aéronef 1.

La globalité du circuit 13 est embarquée dans l'aéronef 1, une partie est intégrée au système de commande 30 (un manche de pas cyclique, par exemple), et certains tronçons de cette partie sont implantés dans le dispositif 10.

Classiquement, un réseau hydraulique 16 lui aussi embarqué dans l'aéronef 1 comporte au moins un réservoir à fluide, des canalisations en boucle, une pompe de mise en circulation de fluide, un filtre, un régulateur de pression, un compensateur.

Bien sûr, on ne doit en aucun cas comprendre comme une limitation, l'exemple de la figure 4 où la commande selon l'invention intervient sur un réseau hydraulique 16.

D'autres types de constituants de l'aéronef 1 par exemple mécaniques, pneumatiques, électriques et autres, sont également aptes à être commandés selon l'invention.

Dans l'exemple de la figure 4, la circulation hydraulique ou l'interruption de mise sous pression dans le réseau 16 est déclenchée in fine par un constituant électro-hydraulique, à savoir une servovalve électro-hydraulique 17 intégrée à une servocommande.

Evidemment, ceci n'est pas limitatif, et le circuit 13 peut alimenter sélectivement en courant électrique un ou plusieurs autres types d'organes de servocommande, comparables à celui qui est désigné en 17.

La servovalve 17 peut donc être vue comme l'interface de contrôle entre le circuit électrique 13 et le réseau 16 hydraulique qui exécute la commande désirée.

Donc, sous l'effet de la commande électrique selon l'invention, la servovalve 17 déclenche ou inhibe l'actionnement ici hydraulique de constituants de l'aéronef 1 que l'on désire contrôler, par exemple le pas des pales du rotor 2.

Sur la figure 4, la servovalve 17 prend la forme d'une électrovanne à solénoïde dont l'état d'excitation ou de repos d'un bobinage électrique, est apte à agir sur un obturateur du réseau hydraulique 16, lui-même capable d'interrompre ou de laisser circuler le flux de fluide à l'intérieur de ce réseau 16.

Ce solénoïde est un organe bistable de servocommande du système 30, qui est lui-même contrôlé par le dispositif 10, au sens où ce dernier agit de façon à provoquer soit l'interruption soit la circulation de courant dans le bobinage dudit solénoïde de la servovalve 17, qui à son tour agit sur la circulation du fluide hydraulique dans le réseau 16.

En observant la figure 4, on retrouve en commun entre un circuit 13 électrique de puissance, et un circuit classique analogue, en général :
- un tronçon de conducteur 18 issu de la phase positive 14 et la reliant en série à un point ou jonction 19 de branchement d'entrée du dispositif 1, appelé tronçon ou conducteur de phase ;
- un agencement 20 dit de coupure, classiquement à bascule ou à poussoir mécanique et donc non statique, apte à couper ou à laisser circuler le courant électrique nominal au sein du circuit 13 de puissance ;
- un tronçon de conducteur 21, appelé tronçon ou conducteur de masse et issu de l'agencement 20 de coupure de tension nominale de façon à relier en sortie cet agencement 20 à la masse 15, via un point ou jonction à branchement en série 22 ; et
- en parallèle du tronçon 21 de masse issu de l'agencement 20, un tronçon conducteur 23 appelé tronçon ou conducteur parallèle, sur lequel est installé en série la servovalve 17.

Dans les dispositifs connus à interrupteur classiques, ce dernier ne nécessite pas de mise à la masse, de sorte que ces dispositifs ne possèdent pas de tronçon de masse propre. Dans le cas où l'invention aboutit à la suppression d'un tel interrupteur classique, un tronçon 21 de masse doit donc être adjoint au circuit existant.

Par contre, dans les dispositifs connus où l'interruption est assurée par un relais classique, il existe un conducteur de mise à la masse au sein de l'alimentation de ce relais. Dans le cas où l'invention vise à la suppression d'un tel relais classique, le conducteur de masse existant peut donc former le tronçon 21.

Dans le circuit 13 propre à l'invention, on voit en outre un tronçon 25 conducteur de dérivation, étendu et relié entre la phase positive 14 et la masse 15.

Ce tronçon 25 de dérivation n'existe pas dans les montages connus, où l'agencement 20 agit seul et de manière mécanique pour assurer le passage ou la coupure du courant électrique nominal entre les points de jonction 19 et 22. En effet, dans les aéronefs 1 connus, l'agencement 20 de coupure est entièrement interposé en série, entre le tronçon 18 de phase et le tronçon 21 de masse.

Dans ces réalisations courantes, une diode 31 de roue libre est souvent montée en série sur le tronçon 21 de masse, entre la jonction 22 et la phase 15, c'est-à-dire en parallèle à la servovalve 17.

Souvent, cette diode 31 est une diode Zenner. Dans une réalisation non illustrée, une diode 31 est intégrée au circuit 13, en amont de l'agencement 20 de coupure sur le tronçon 18 de phase et en aval de la dérivation vers le tronçon 25.

Classiquement, l'agencement 20 de coupure des montages connus est un simple interrupteur à contacts agissant directement sous l'effet d'une impulsion manuelle, en coupure ou en fermeture électrique, sur le courant dans le circuit de puissance 13.

Donc, un tel agencement 20 de coupure connu est apte à modifier mécaniquement le tracé du circuit 13, afin de laisser circuler ou d'interrompre le courant sous la tension nominale de 28,5 Volts au sein de ce circuit 13 et ainsi d'alimenter ou non le solénoïde de la servovalve 17.

Un tel agencement 20 de coupure possède d'une part une touche manuelle de manoeuvre à poussoir, à bascule ou analogues, qui est sensiblement comparable à celle qui est désignée en 24 sur la figure 4. Notons cependant que la touche 24 de manoeuvre de l'invention est déportée à distance des tronçons 18 et 21 où le courant nominal de puissance circule.

Dans les techniques connues tout comme avec l'invention, c'est évidemment sur cette touche manuelle, couplée à l'agencement 20, que l'opérateur agit en vue d'obtenir une réaction de l'aéronef 1.

Mais avec un agencement 20 de coupure usuel, la mise en circulation et la coupure du courant sont mécaniques, c'est-à-dire modifient physiquement le tracé du circuit 13.

Dans les montages connus, la touche manuelle de manoeuvre est directement couplée à l'agencement 20 et souvent disposée sensiblement sur cet agencement 20 de coupure.

Cette touche manuelle connue agit directement sur l'agencement 20 de coupure, en modifiant mécaniquement son circuit interne, de sorte que le courant est soit passant à tension et intensité nominales, soit coupé.

Il en résulte qu'en ouvrant localement un circuit 13 conventionnel à l'aide d'un agencement 20 usuel, la tension et l'intensité passent brutalement de leurs valeurs nominales à des valeurs respectivement nulles.

Similairement, la résistance d'un tel agencement de coupure est minime voire nulle s'il ferme le circuit de puissance, et infinie s'il l'ouvre. Ce qui explique l'apparition des arcs électriques indésirables lors de ces manoeuvres.

En référence à la figure 4, notons que contrairement aux dispositifs 10 connus, on utilise selon l'invention une touche 24 distale de l'agencement 20 de coupure lequel, ici, n'est pas mécanique. On entend par distale, que la touche 24 manuelle de manoeuvre est distincte physiquement, bien que liée d'un point de vue fonctionnel, de l'agencement 20 de coupure. Bien que fonctionnellement liés, la touche 24 et l'agencement 20 ne sont pas en interaction directe, selon l'invention.

Il va de soi que c'est notamment cette touche 24 qui est à portée de main, puisque c'est elle qui est manipulée par l'opérateur pour actionner la commande désirée. Tel n'est pas forcément le cas pour l'agencement 20, qui peut être inaccessible à l'opérateur.

Contrairement aux techniques connues et en d'autres termes, le système 30 selon l'invention est tel que la touche manuelle 24 n'opère pas directement sur l'agencement 20 où circule la tension nominale.

Par contre, le système 30 selon l'invention agit exclusivement, via la touche 24 et un organe interrupteur 26, distinct de l'agencement 20, sur la circulation du courant électrique à travers une section 27 de liaison, qui relie le tronçon 25 de dérivation à l'agencement 20 de coupure, en parallèle du tronçon 18 de phase et du tronçon 21 de masse.

A toutes fins utiles, précisons que le tronçon 25 tout comme la section 27 de liaison, font partie de l'aéronef 1 et sont reliés au circuit 13.

On en verra les raisons ultérieurement, mais notons dès maintenant que l'intensité du courant électrique passant dans cette section 27 de liaison est nettement inférieure aux valeurs nominales mesurées dans le tronçon 18 de phase et le tronçon 21 de masse notamment.

On verra en effet qu'un courant électrique réduit circule dans cette section 27 de liaison parallèle au tronçon 25 de dérivation.

D'ores et déjà, on remarque que paradoxalement l'invention ajoute à un circuit 13 classique, notamment une dérivation avec une section de liaison 27 à un agencement 20 de coupure qui n'est pas mécanique, alors même qu'usuellement une amélioration de la fiabilité tend plutôt vers la simplification.

Ceci est d'autant plus vrai dans le domaine de l'aéronautique, que de véritables campagnes de réduction de masse sont entreprises sur la plupart des constituants d'aéronefs.

Afin de transmettre les instructions manuelles d'ouverture ou de fermeture du circuit 13, la touche 24 est couplée mécaniquement à l'organe interrupteur 26.

Cet organe 26 interrupteur modifie mécaniquement son circuit interne sous l'effet des manoeuvres appliquées à la touche 24. Il en résulte l'ouverture ou la fermeture de la section 27 de liaison.

De la sorte, le courant électrique dans ladite section 27 de liaison est soit passant, soit coupé par l'organe 26, selon la manoeuvre opérée sur la touche 24.

Du fait que l'agencement 20 n'est pas mécanique mais statique, l'intensité dans la section 27 de liaison est particulièrement faible lorsque le tronçon 25 de dérivation est fermé, et totalement nulle évidemment comme dans le tronçon 25 lorsque ce tronçon 25 est ouvert par l'organe 26.

Autrement dit, lorsque le circuit 13 est passant, l'agencement 20 n'est pas traversé par le courant issu de cette section 27 de liaison, mais seulement par le courant nominal issu de phase positive 14.

Contrairement à l'agencement 20, l'organe 26 est solidaire de la touche 24 de manoeuvre, au sens où un changement d'état (appuyé ou basculé, ou non) de cette touche 24, provoque directement une modification correspondante de l'organe 26.

A ce stade, rappelons qu'avec un agencement 20 usuel, on agit directement sur la tension nominale de puissance, ce qui constitue une source considérable d'arcs pouvant aboutir à un charbonnage.

Par exemple, les systèmes 30 de commande connus comportent des touches à agencements 20 sous forme de boutons poussoirs tels que des touches secteur sur une commande de pas collectif d'hélicoptère.

D'autres systèmes 30 connus disposent d'agencements 20 sous forme de bascules bistables (marche / arrêt = on / off) dans le cas d'un inverseur de réseau hydraulique sur une poignée de pas collectif.

Les spécificités de tels systèmes 30 connus, sont prévues par exemple par la norme MS27718-23-1 pour équipement militaire aux U.S.A.

Dans d'autres réalisations, les systèmes 30 de commande connus comportent un relais ou analogue, en tant qu'agencement 20.

On comprend bien que tous ces agencements connus de coupure agissent sur la tension nominale, par ouverture mécanique locale du circuit 13.

On a vu sur la figure 4, que le circuit 13 de l'invention comporte pour sa part, en plus des tronçons 18 de phase, de masse 21 et parallèle 23, le tronçon de dérivation 25 qui relie le tronçon 18 à proximité de la phase 14, au tronçon 21 à proximité de la masse 15.

Dans le circuit 13 propre à l'invention, la section 27 de liaison relie comme on l'a vu, ce tronçon 25 à l'agencement 20 de coupure.

Cependant, selon l'invention l'agencement 20 de coupure est statique au sens où seul un effet de champ peut transiter entre cet agencement 20 et la section 27 de liaison, pour provoquer l'ouverture ou la fermeture du circuit entre les tronçons 18 et 21.

Selon l'invention, on a vu que sur le tronçon 25 de dérivation, le dispositif de commande 10 possède d'une part la touche 24 de manoeuvre manuelle coopérant avec l'organe 26 interrupteur.

D'autre part, le dispositif 10 selon l'invention comporte un agencement 20 de coupure ou de circulation de la tension nominale, de type statique. Cet agencement 20 de type statique, possède selon l'invention trois bornes d'entrée / sortie :
- une grille 33 reliée à la section 27 de liaison ;
- une source reliée au tronçon 18 de phase ; et
- un drain relié au tronçon 21 de masse.

Selon l'invention, l'organe 26 interrupteur agit non pas sur le courant à valeurs nominales comme dans les conducteurs de puissance entre les tronçons 18 et 21, mais est prévu pour couper ou assurer la circulation d'un courant électrique vers la section 27 de liaison où le courant est faible.

Plus précisément, grâce à l'invention, l'intensité du courant dans la section 27 de liaison est sensiblement voire totalement nulle.

En effet, si dans un premier cas l'organe 26 interrupteur est ouvert, c'est-à-dire inhibe le passage du courant électrique à partir de la phase 14 dans la section 27, l'intensité localement dans cette section 27 est évidemment nulle.

Quand dans un deuxième cas l'organe 26 est fermé, c'est-à-dire dévie le courant électrique depuis la phase 14 vers la section 27, l'intensité localement dans la section 27 de liaison est faible.

De la sorte, l'organe 26 est soumis lors de son basculement, au passage d'un courant électrique d'une intensité nulle à une faible intensité et vice-versa. Par suite, le charbonnage entre l'organe 26 et la touche 24 est extrêmement réduit, voire inexistant.

Ce résultat est relatif au fait que la grille 33 de l'agencement 20 de coupure à laquelle est relié le tronçon 25 via la section 27 de liaison, est électriquement isolée du tronçon 21 de sortie qui rejoint l'agencement 20 à la masse 15 : le courant électrique ne peut circuler entre les bornes 19 et 22.

Néanmoins, lorsque la grille 33 est alimentée électriquement via l'organe 26 et la section 27, la circulation du courant électrique nominal entre la source et le drain de l'agencement 20 est effective, c'est-à-dire entre les bornes d'entrée 19 et de sortie 22, et donc entre la phase 14 et la masse 15.

En fait, l'invention dédouble en apparence les composants qui permettent de choisir le passage ou l'interruption des courants, puisque le dispositif 10 inventif présente à la fois un organe d'interruption électrique 26 mécanique pour basse intensité et un agencement 20 de coupure statique pour l'intensité nominale de puissance.

A priori, cette sorte de dédoublement fonctionnel pourrait paraitre opposée aux objectifs de légèreté, simplicité et fiabilité de l'invention. Etonnement, il permet à l'invention de mieux les atteindre.

Notons à ce stade, que dans la réalisation illustrée à la figure 4, une impédance ou composant résistant 28 est monté en série sur la section 27 de liaison, entre la sortie de l'organe 26 interrupteur et l'entrée de l'agencement 20 de coupure.

Ce composant résistant 28 est optionnel, bien qu'il soit prévu dans nombre de réalisations de l'invention.

Cette impédance ou composant résistant 28 a notamment pour fonction d'assurer que par rapport à sa valeur nominale (ici 4 à 10 Ampères), l'intensité dans la section 27 de liaison est négligeable.

Dans l'exemple de la figure 4, ce composant résistant 28 possède une impédance de l'ordre de l'ordre de 10⁴ Ohms (10 kOhms). Selon des réalisations possédant un tel composant résistant 28, l'impédance de celui-ci est, pour une tension nominale de l'ordre de 28,5 Volts, typiquement inférieure ou égale à 20.000 Ohms.

Cependant, dans l'exemple de la figure 4, ce composant résistant 28 n'assure pas l'obtention d'une intensité nulle dans la section 27 de liaison. La valeur de l'intensité dans la section 27 est le résultat du fait que l'agencement 20 de coupure est statique et ne relie pas du point de vue de la conduction électrique, cette section 27 aux tronçons 18 et 21.

On a vu que dans une telle configuration, l'organe interrupteur 26 opère la commande (transition d'un état passant à un état de coupure du courant de puissance, et inversement) en tension avec un courant d'intensité quasi-nulle (à considérer comme nulle), et de manière statique.

A cette fin, dans le cas d'un courant à tension nominale de l'ordre de 28,5 Volts et si l'impédance du composant 28 est de l'ordre de 10⁴ Ohms (10 kOhms), l'intensité du courant électrique circulant dans la section 27 de liaison est sinon quasi nulle du moins extrêmement faible quand l'organe interrupteur 26 relie électriquement la section de liaison 27 à la phase 14, et nulle quand la connexion électrique est établie entre le tronçon de dérivation 25 et ladite section 27.

Dans l'agencement 20 selon l'invention, en mode saturé la résistance entre le tronçon 18 côté source et le tronçon 21 côté drain est très élevée, sinon cette résistance est particulièrement faible, par exemple de l'ordre de 0,01 Ohm (10⁻² Ohm).

De fait, il est possible d'obtenir avec l'invention, une commande à la grille 33 qui s'opère en tension avec un courant électrique quasi nul de l'ordre de 10⁻² Ampères (10 mA). En outre, les transitions sont opérées selon l'invention entre les états passants et coupés, de manière progressive et dans une marge de moindre amplitude, sous l'effet de champ.

Dans un autre exemple, cette intensité est de l'ordre de 0,0028 Ampères, ce qui est à rapprocher d'une intensité nominale de l'ordre de 3,6 Ampères qui est classique dans les aéronefs 1.

Selon l'invention, l'agencement 20 contrôlé par la touche 24 est essentiellement composé d'un transistor à effet de champ à grille métal-oxyde dit MOSFET. Cet agencement 20 est statique, puisqu'il ne laisse pas circuler à travers lui le courant issu de la section 27 de liaison.

Un avantage du maintien de faibles intensités est d'éviter d'avoir à recourir à un refroidissement du dispositif 10, par exemple à un radiateur d'évacuation de la chaleur provoquée par les tensions et ampérages constatés avec les techniques connues.

Notons également que le tronçon 21 de masse sert notamment à bloquer le transistor MOSET de l'agencement 20 en régime non passant, c'est-à-dire dans un état ouvert. Dans un exemple, cet agencement 20 comporte un composant du type tel que le transistor de STMicroelectronics de référence STP80PF55 (P-Channel 55V - 0.016Ω 80A TO-220), lequel présente une tension admissible drain-source de l'ordre de 55 Volts, et une tension porte-source sensiblement nulle. Sa dissipation thermique à 25°c est de l'ordre de 300 Watts, et son « continuos » à cette même température du courant de drain est de l'ordre de 80 Ampères.

Dans un autre exemple, un agencement 20 à MOSFET qui peut être intégré au système 30, est un transistor IRF5M4905 de International Rectifier (P-Channel 55V - 0.03Ω 80A TO-254AA), qui présente lui aussi une tension admissible drain-source de l'ordre de 55 Volts, et une tension grille-source sensiblement nulle.

En comparant les spécifications de ces deux exemples, notamment en termes de valeur nominale de tension et d'intensité, on comprend que l'agencement 20 à MOSFET est « surabondant ».

Par ce terme, on signifie en quelque sorte que le composant de l'agencement 20 est ici surdimensionné, au sens où ses spécifications autorisent selon les de spécifications une tension de l'ordre de 55 Volts et une intensité de l'ordre de 80 Ampères, alors que les valeurs nominales du circuit 13 sont respectivement de l'ordre de 28 Volts et 1 à 10 Ampères. Le choix de composants qui rendent surabondant le dispositif 10 de commande et ainsi le système 30, est fréquemment tel qu'un coefficient S_{V} et S_{A} compris entre au moins 1,5 et 3 est appliqué de sorte que :
- Tension nominale x S_{V} ≤ Tension de spécification du composant 20 à MOSFET ; et / ou
- Intensité nominale x S_{A} ≤ Intensité de spécification du composant 20 à MOSFET.

La surabondance de l'agencement 20 est un facteur utile d'une part pour limiter au minimum les échauffements indésirables du système 30, qui peuvent s'avérer désagréables pour leur opérateur.

D'autre part, ceci limite aussi les risques déjà négligeables de charbonnages ou d'arcs.

En se reportant toujours à la figure 4, on comprend qu'il est aisé d'intégrer l'agencement 20, l'impédance 28, la touche 24 et son organe interrupteur 26, à un dispositif 10 de commande unitaire et compatible avec les dimensions, forme et connectique existants sur le système 30 de destination, par exemple dans le cas d'un échange avec un dispositif connu de commande à coupure mécanique de la tension nominale.

Ainsi, l'interchangeabilité peut être parfaite, au sens où il suffit d'extraire le dispositif connu hors du système 30, par exemple un levier de pas collectif, et de lui substituer un dispositif 10 de commande selon l'invention.

Toutefois, on rappelle que dans le cas où l'invention permet la suppression d'un interrupteur classique, un tronçon conducteur de masse est à rajouter au sein du dispositif 10, à la borne appropriée.

Notons également que le choix d'une touche 24 de type à deux contacts bistables, avec un point milieu relié à la grille 33 du transistor à effet de champ, présente l'avantage de protéger efficacement l'agencement 20 contre les perturbations électromagnétiques.

Dans la réalisation de la figure 4, le dispositif 10 de l'invention forme un boîtier intégré, avec à une interface externe, des plots de connexion aux points de jonction 19 et 22 bien sûr, mais aussi à des point 34 et 35 de jonction sur le tronçon 25 de dérivation.

Des guides d'insertion 36, représentés pas des glissières sur la figure 4, permettent une insertion par coulissement rectiligne de ce dispositif 10 dans un logement sensiblement complémentaire du système 30 et formant réceptacle, qui est schématisé en 37.

Dans une réalisation, ces guides d'insertion 36 ainsi que les logements complémentaires 37 présentent au moins un détrompeur 38 (par exemple asymétrique) afin de rendre impossible les erreurs de montage du dispositif 10 sur l'aéronef 1.

Une schématisation d'un tel agencement 20 de coupure au nominal, est représentée à la figure 5. Cet agencement ou composant 20 fait évidemment partie du dispositif 10 de commande, et du système 30, conformes à l'invention.

Avec cet agencement 20 à MOSFET, on obtient une interruption statique en mode saturé. C'est pourquoi on peut dire qu'avec l'invention, la commande se fait « en tension », avec une intensité à considérer comme nulle ou quasi-nulle.

En effet, on comprend qu'un pareil agencement 20 module de manière statique le courant électrique du circuit 13 qui le traverse et que l'on désire pouvoir commuter, en fonction d'un effet de champ produit à l'aide d'un signal à faible tension appliqué à ladite grille 33.

La tension faible ainsi appliquée à la grille 33 provoque par effet de champ, la modification interne de la conductivité, c'est-à-dire une transformation statique sans dérivation mécanique ou physique, ce qui opère la commande « en tension ».

Sur la figure 5, on a représenté en traits discontinus et pointillés, une autre version intégrée du dispositif 10 de commande sécurisé selon l'invention.

On remarque sur cette figure 5, qu'une diode 40 est intégrée au composant à MOFSET, en parallèle des jonctions d'entrée 19 et de sortie 22 du circuit 13. Cette diode 40, par exemple de type Zenner, peut remplacer la diode 31 dans une réalisation entièrement intégrée de l'invention. Dans une autre réalisation, la diode 31 du dispositif 10 est simplement montée sur un tronçon conducteur, la diode 40 restant quant à elle intégrée au composant à MOFSET.

Cette version comporte un boitier comparable à celui de la figure 4, et un tracé conducteur spécifique, par exemple sur une carte imprimée ou analogues.

Avec cette version, au montage des guides 36 dans les logements 37 du système 30, sont simultanément effectuées deux connexions électriques.

En fait, dans cette réalisation, en dehors du dispositif 10, la partie externe du circuit de puissance 13 comporte les points 19 et 22, le premier relié à la phase positive 14 et le second à la masse 15.

Dans le dispositif 10, sont prévus des raccords doubles, de mise en place de la dérivation nécessaire à l'invention.

D'un côté, les points 19 et 22 viennent se coupler à une section 25 de dérivation, fonctionnellement similaire à celle qui est illustrée sur la figure 4, mais remarquable en cela que cette section 25 de dérivation est intégrée entièrement au dispositif 10.

De l'autre côté, les points 19 et 22 viennent se coupler à l'agencement 20 de coupure à effet de champ.

A ces points 19 et 22, s'opère la double connexion électrique en question, de telle sorte que ce branchement unique relie en parallèle d'abord la section 25 intégrée de dérivation puis en série le branchement de l'agencement 20 de coupure.

Toujours au sein du dispositif 10, sont prévus des raccords 39 et 42 à l'organe interrupteur 26, à la section 27 de liaison et à la résistance 28, qui elle-même se branche à l'entrée de la grille 33 de l'agencement 20.

On voit ainsi sur la figure 5 que le dispositif 10 possède des fiches de branchement respectivement aux points 19 et 22.En d'autres termes, avant montage le circuit 13 ne possède pas initialement de section 25 de dérivation, tandis qu'après insertion du boitier contenant le dispositif 10, son tracé conducteur spécifique - dont deux raccords 39 et 42- forme en parallèle la section 25 de dérivation, et les tronçons classiques qui relient en série la phase 14, le composant 20 et la masse 15.

Un raccord 39 relié via le point 19, le conducteur d'entrée 18 et la sortie électrique de l'organe 26 interrupteur.

Un raccord 42 reliant la section 27 de liaison, rejoint à proximité du point 22 le conducteur de connexion du circuit en parallèle vers la masse 15.

Ces raccords 39 et 42 font ici partie du circuit qui est intégré au boitier unitaire c'est-à-dire monobloc et compact, pour former le dispositif 10 de commande.

On comprend que dans ce cas, l'interchangeabilité est facilitée, puisqu'il suffit de brancher ce dispositif 10 pour réaliser la dérivation 25 et y coupler l'organe 26 obéissant à la touche 24 avec la grille 33 de l'agencement 20 de coupure.

Ces explications étant données, on peut résumer l'invention et son contexte d'origine comme suit.

Des incidents et accidents ont probablement eu pour origine une dégradation d'un interrupteur proximal, en particulier l'interrupteur électrique de commande (marche / arrêt) d'urgence d'un réseau hydraulique d'aéronef ou d'une commande de Trim afin d'éviter les déroulements intempestifs.

On appelle cette dégradation « charbonnage ». Comme on l'a vu, ceci signifie que suite à des arcs répétés de coupure du circuit électrique, les contacts physiques de coupure et de circulation de courant électrique s'encrassent et s'altèrent (voire sont détruits) au point de ne plus être opérationnels.

Dès lors, les actions manuelles du pilote de l'aéronef ne provoquent plus la réponse voulue au niveau du réseau 16 hydraulique, ou à l'inverse provoquent le maintien de la réponse alors que l'action cessé.

Dans l'exemple ci-dessus, cette réponse non obtenue est par exemple la coupure d'urgence dudit réseau hydraulique.

Face à cette situation, il a paru nécessaire de sécuriser les dispositifs sensibles au charbonnage qui sont actuellement en service et d'éviter la survenue d'incidents ou d'accidents causés par ces dispositifs pour les aéronefs 1 du futur.

Ceci pose, on l'a vu, divers problèmes techniques. Sans ordre d'importance, cette mise en sécurité ne doit pas provoquer pour les aéronefs existants, de modifications trop lourdes des équipements en place, et notamment du circuit électrique.

L'exemple de la figure 5 est particulièrement évocateur à cet égard.

Egalement, du fait des contacts physiques fréquents des mains de l'opérateur avec ces dispositifs interrupteurs proximaux (typiquement sur la planche de bord, le manche de pas collectif, le levier de pas cyclique ou le pupitre de commandes systèmes), la mise sous tension ainsi que les opérations de ces dispositifs 10 de commandes, ne doivent pas provoquer un échauffement excessif de leur environnement, qui serait sinon désagréable, au pire blessant pour les mains de l'opérateur.

Dans le même ordre d'idées, une diode de roue libre peut si nécessaire, être intégrée à l'invention, en amont et / ou en aval de l'agencement 20 de coupure statique.

En outre, les aéronefs tels que celui désigné en 1 étant appelés à fonctionner parfois dans des situations extrêmes (températures très chaudes ou froides, tempêtes, opérations de sauvetage ou théâtres guerriers, voire pollution nucléaire), il est important pour nombre de ces appareils, de pouvoir garantir la fiabilité de ses commandes dans de pareilles situations.

Classiquement dans le domaine aéronautique en particulier, les contraintes de légèreté, de compacité (encombrement) et de coût, limitent les possibilités offertes par une analyse purement fonctionnelle.

L'invention s'inscrit dans ce contexte. Soulignons encore que les transistors à effet de champ sont connus depuis les années 1920, et avaient dès cette époque été proposés pour la commande de courants électriques. Puis, les MOSFET, à grille métal-oxyde, ont été de plus en plus intégrés aux circuits d'électronique de puissance.

Cependant, de manière surprenante, ces MOFSET n'ont jusqu'à présent pas été employés en pratique, pour pallier les problèmes résolus par l'invention, sur les commandes d'aéronefs.

Dans un exemple d'application de l'invention à un hélicoptère, on obtient en quelque sorte une solution « statique » aux dégâts provoqués par la coupure d'intensités de l'ordre de 4 à 10 Ampères, voire bien plus dans certaines applications, solution qui implique des interrupteurs particulièrement compacts, par exemple pouvant être intégrés à la poignée d'un manche de pas collectif dans le cas d'un interrupteur d'urgence du circuit hydraulique.

On a vu qu'ici, le terme « statique » signifie que ce ne sont pas directement les déplacements de l'organe de commutation actionnable manuellement qui provoque un changement mécanique d'état (ouvert vs fermé) du circuit électrique de puissance (par exemple sensiblement 28 Volts et au plus quelques Ampères d'intensité) à piloter, mais une modification interne de la conductivité d'une dérivation où l'intensité de commande ainsi que la résistance sur le circuit de puissance ne dépassent pas des valeurs spécialement faibles (par exemple de l'ordre respectivement de 10 mA et 0,01 Ohm).

L'intérêt de cette interruption statique est qu'en mode saturé, la résistance entre la source et le drain du composant (le MOSFET) placé sur la dérivation est soit très grande, soit très faible. De plus, la borne faisant office de commande, c'est-à-dire la grille 33, est isolée du circuit drain - source, cette commande se faisant en tension, avec un courant quasi-nul.

En effet, on sait qu'un composant MOSFET module le courant électrique qui le traverse (ici, celui que l'on désire commuter) à l'aide d'un signal appliqué à son électrode dite grille, qui est considérée comme l'entrée de ce composant.

La tension ainsi appliquée provoque l'effet de champ qui lui-même aboutit à la modification interne de la conductivité de la dérivation : c'est donc une commande « en tension ».

Notons que dans les exemples, le composant MOFSET est de type P du fait de la polarité de ses porteurs de charge qui sont positifs, et de la catégorie des transistors à effet de champ à grille métal-oxyde dont le mode d'opération est dit à inversion (en langue anglais : depletion mode). Ceci ressort d'ailleurs de la figure 5.

Un tel composant P à inversion permet de maintenir le reste du circuit dans sa définition antérieure (toujours reliée à la masse), en cas de modification sur un appareil existant. Ceci facilite donc l'interchangeabilité visée par l'invention.

Des essais en laboratoire ont été effectués pour vérifier l'adéquation de l'invention avec ses objectifs, notamment en termes de sécurité et de chauffe, avec des résultats probants.

L'invention n'est néanmoins pas limitée aux modes de réalisation exposés. A l'inverse, elle comprend tous les équivalents des caractéristiques décrites.

## Revendications

1. Dispositif (10) de commande électrique, manuelle et sensible au charbonnage pour un aéronef (1) ; ce dispositif (10) assurant le passage ou la coupure d'un courant nominal de puissance au sein d'un circuit (13) de puissance avec un tronçon de phase (18) reliant le dispositif (10) à une phase (14), un tronçon de masse (21) reliant le dispositif à une masse (15) et une touche (24) de manoeuvre manuelle coopérant avec un agencement (20) de coupure dudit courant nominal,
**caractérisé en ce que** ledit dispositif (10) de commande est au moins en partie intégré à au moins une commande de vol ; ledit dispositif (10) comportant en outre, un tronçon (25) de dérivation et une section résistante (27) de liaison, en entrée de laquelle est raccordé un organe (26) interrupteur qui est fonctionnellement relié à ladite touche (24) manuelle ; la sortie de la section résistante (27) étant raccordée une grille (33) d'un agencement (20) de coupure sous forme de transistor à effet de champ à grille métal-oxyde ou MOSFET ; ledit agencement (20) de coupure comportant une porte et un drain montés en série entre les tronçons de phase (14) et de masse (21) du circuit (13) sous tension nominale et faisant partie d'un composant intégré interchangeable sous forme d'un boîtier unitaire.

2. Dispositif (10) selon la revendication 1,
**caractérisé en ce que** ledit dispositif (10) est surabondant au sens où ledit agencement (20) de coupure autorise des coefficients S_{V} et S_{A} compris au moins entre 1,5 et 3 de sorte que :
- Tension nominale du dispositif (10) de commande x S_{V} ≤ Tension de spécification de l'agencement (20) de coupure ; et / ou
- Intensité nominale du dispositif (10) de commande x S_{A} ≤ Intensité de spécification de l'agencement (20) de coupure.

3. Dispositif (10) selon la revendication 2,
**caractérisé en ce que** ladite tension de spécification de l'agencement (20) de coupure surabondant est de l'ordre de 35 à 65 Volts et l'intensité de spécification de cet agencement (20) de coupure est de l'ordre de 20 à 80 Ampères, alors que les valeurs correspondantes observées au sein du circuit (13) de puissance sont respectivement de l'ordre de 28,5 Volts et 3 à 10 Ampères.

4. Dispositif (10) selon l'une des revendications 1 à 3,
**caractérisé en ce que** ledit dispositif (10) comporte un transistor à effet de champ à grille métal-oxyde unique, ce transistor faisant partie intégrante de l'agencement (20) de coupure.

5. Dispositif (10) selon l'une des revendications 1 à 4,
**caractérisé en ce que** ledit l'agencement (20) de coupure à transistor à effet de champ à grille métal-oxyde fait qui partie d'un composant intégré comporte un composant (28) résistant et / ou une diode (31, 40) de roue libre, par exemple cette diode étant de type Zenner et / ou l'impédance dudit composant (28) résistant étant inférieure ou égale à 10.000 ou 20.000 Ohms.

6. Système (30) de commande, qui comporte au moins un dispositif (10) selon l'une des revendications 1 à 5,
**caractérisé en ce que** ledit dispositif (10) comporte un boîtier intégré, avec à une interface externe, des plots de connexion à des points de jonction du circuit (13) de puissance, des point de jonction au tronçon (25) dérivé, et des guides (36) d'insertion tels que des glissières, qui permettent une insertion par coulissement rectiligne dudit dispositif de commande dans un logement (37) sensiblement complémentaire du système (30) formant alors réceptacle.

7. Système (30) de commande selon la revendication 6,
**caractérisé en ce que** ledit système (30) comporte au moins un dispositif (10) de commande intégré, au sein duquel sont formés en parallèle la section (27) de liaison à faible intensité, ainsi qu'au moins une partie des tronçons de phase (18) et de masse (21) avec l'agencement (20) de coupure du nominal.

8. Aéronef (1) comportant au moins un dispositif (10) selon l'une des revendications 1 à 5 et/ou un système (30) selon la revendication 7,
**caractérisé en ce que** ladite commande de vol à laquelle le dispositif (10) de commande est au moins en partie intégré comporte un manche de pas cyclique ou levier de pas collectif d'un hélicoptère, une planche de bord et / ou un pupitre de contrôle.

9. Aéronef (1) comportant au moins un dispositif (10) selon l'une des revendications 1 à 5 et / ou un système (30) selon la revendication 7,
**caractérisé en ce que** ledit aéronef (1) est à voilure tournante et est radio guidé et au moins une partie du dispositif (10) de commande est embarquée dans l'aéronef, tandis qu'au moins la touche de manoeuvre est intégrée à un ensemble hors bord, par exemple destiné à être porté par un opérateur au sol.
